Europäisches Patentamt

European Patent Office

Office européen des brevets

(11) Numéro de publication: **0 236 189 B1**

(12) **FASCICULE DE BREVET EUROPEEN**

(45) Date de publication de fascicule du brevet: **06.05.92**

(51) Int. Cl.5: **H01L 27/15**, //G02B6/12, H01S3/19

(21) Numéro de dépôt: **87400230.6**

(22) Date de dépôt: **02.02.87**

(54) **Structure semi-conductrice monolithique d'un transistor bipolaire à hétérojonction et d'un laser.**

(30) Priorité: **04.02.86 FR 8601508**

(43) Date de publication de la demande:
**09.09.87 Bulletin 87/37**

(45) Mention de la délivrance du brevet:
**06.05.92 Bulletin 92/19**

(84) Etats contractants désignés:
**DE GB NL**

(56) Documents cités:
**EP-A- 0 129 477**
**EP-A- 0 166 593**

**APPLIED PHYSICS LETTERS, vol. 37, no. 2, 15 juillet 1980, pages 211-213, American Institute of Physics, New York, US; J. KATZ et al.: "A monolithic integration of GaAs/GaAlAs bipolar transistor and heterostructure laser"**

**J.E.E. JOURNAL OF ELECTRONIC ENGINEERING, vol. 21, no. 213, septembre 1984, page 21, Tokyo, Japan; "Fujitsu refines method for semiconductor lasers"**

**IEEE TRANSACTIONS ON ELECTRON DEVI-**

**CES, vol. ED-29, no. 9, septembre 1982, pages 1372-1381, New York, US; N. BAR-CHAIM et al.: "GaAs integrated optoelectronics"**

(73) Titulaire: **Ankri, David**
**86, rue Amiral Roussin**
**F-75015 Paris(FR)**

Titulaire: **Palmier, Jean-François**
**9, rue Léon Bloy**
**F-92260 Fontenay aux Roses(FR)**

(72) Inventeur: **Ankri, David**
**86, rue Amiral Roussin**
**F-75015 Paris(FR)**
Inventeur: **Palmier, Jean-François**
**9, rue Léon Bloy**
**F-92260 Fontenay aux Roses(FR)**

(74) Mandataire: **Mongrédien, André et al**
**c/o BREVATOME 25, rue de Ponthieu**
**F-75008 Paris(FR)**

## Description

La présente invention a pour objet une structure plane semi-conductrice monolithique d'un transistor bipolaire à hétérojonction et d'un laser ; ce transistor fait partie du circuit de commande ou de modulation du laser. L'invention s'applique principalement dans le domaine de la télémétrie, de l'optique intégrée ou des télécommunications par fibre optique.

De façon plus précise, l'invention se rapporte à une structure laser-transistor bipolaire à hétérojonction intégrée, plane, réalisée sur un substrat semi-conducteur en matériau III-V.

Comme solution d'intégration connue d'un transistor bipolaire à hétérojonction et d'une source laser, on peut citer celle décrite dans l'article de Appl. Phys. Lett. 37(2), du 15 juillet 1980, p. 211-213, intitulée "A monolithic integration of GaAs/GaAlAs bipolar transistor and heterostructure laser" de J KATZ et al. Dans cette solution d'intégration, le laser et le transistor bipolaire sont juxtaposés sur le même substrat semi-conducteur en GaAs sur lequel sont épitaxiées les différentes couches semi-conductrices dans lesquelles sont définies les jonctions du laser et du transistor. Dans cette structure monolithique, le laser présente un courant de seuil relativement élevé, et donc une importante dissipation énergétique, ainsi qu'un faible rendement différentiel et donc la nécessité d'un important courant de modulation.

Comme autre solution d'intégration d'un laser et d'un transistor, on peut citer celle décrite dans l'article Appl. Phys. Lett. 46(3), de février 1985, p. 226-228, intitulée "Monolithic integration of Low Threshold current quantum well laser and a driver circuit on a GaAs substrate" de T. SANADA et al. Dans cette solution, le transistor utilisé est un transistor à effet de champ. En outre, le laser est un laser à injection verticale des électrons et la couche active du laser est pourvue d'un "GRINSCH" (graded index separate confinement heterostructure en terminologie anglosaxonne), c'est-à-dire une zone de confinement des porteurs à variation d'indice.

Les avantages d'une telle structure laser sont notamment un faible courant de seuil, et par conséquent une faible dissipation énergétique et la nécessité d'un faible courant de modulation. En outre, la structure laser-transistor à effet de champ correspondante présente une faible sensibilité thermique ; elle peut fonctionner à température élevée.

Les performances de cette structure laser-transistor à effet de champ intégrée, sont donc très proches de celles des composants discrets. Cependant, pour la réalisation d'un transistor à grille courte et donc d'un transistor à transconductance élevée, il est nécessaire de former le laser au fond d'un trou. Cette technologie est relativement délicate et pose notamment des problèmes en ce qui concerne la réalisation des masques de résine, selon la technologie de photolithographie, servant à définir les dimensions de la grille du transistor. Cette technologie est difficilement reproductible. En outre, pour augmenter la fiabilité de la réalisation du transistor, les couches semi-conductrices de ce composant doivent être réalisées après l'épitaxie des couches conductrices du laser, lors d'épitaxie supplémentaire. Ces reprises d'épitaxie ionique risquent par ailleurs de détériorer les performances du laser.

L'invention a justement pour objet une structure semi-conductrice monolithique d'un transistor bipolaire à hétérojonction et d'un laser permettant de remédier aux différents inconvénients donnés ci-dessus. En particulier, elle permet une véritable intégration du laser et d'un transistor selon une structure entièrement plane, à partir d'une seule épitaxie du substrat semi-conducteur. Par ailleurs, le laser présente un faible courant de seuil et un fort rendement différentiel.

De façon plus précise, l'invention a pour objet une structure semi-conductrice monolithique d'un transistor bipolaire à hétérojonction et d'un laser caractérisée en ce qu'elle comprend :

- une hétérostructure comportant une première, une seconde et une troisième couches semi-conductrices superposées dans cet ordre, la première et la troisième couches étant réalisées en des matériaux d'un premier type de conductivité ayant des largeurs de bande interdite au moins égales à celles de la seconde couche cette seconde couche, constituant la couche active du laser et la base du transistor, présentant un second type de conductivité différent, du premier type et étant constituée d'une hétérostructure de plusieurs matériaux de largeur de bande interdite différente, définissant au moins une zone de confinement des porteurs uniquement pour le laser, orientée parallèlement aux première et troisième couches,
- une première région s'étendant au moins d'une face à l'autre de la troisième couche et ayant le second type de conductivité, cette première région définissant avec la troisième couche la jonction du laser, et
- des moyens pour alimenter en courant le laser et le transistor.

Dans la suite du texte, la seconde couche semi-conductrice de la structure formant la couche active du laser et la base du transistor sera appelée couche active de la structure.

La structure monolithique selon l'invention, en plus des avantages cités ci-dessus, est relativement simple et ne pose aucun problème quant à sa fabrication. En outre, elle présente une faible sensibilité thermique.

Contrairement à ce qu'on aurait pu prévoir, les inventeurs ont trouvé que l'intégration d'une source laser et d'un transistor bipolaire, en utilisant comme couche active pour le laser et le transistor une hétérostructure définissant au moins une zone de confinement des porteurs, satisfaisant à certaines conditions, était compatible.

Or, on sait que le confinement des porteurs dans la zone active du laser est bénéfique pour augmenter le nombre de recombinaisons entre les électrons et les trous et donc l'émission de lumière. En revanche, dans un transistor la présence d'une zone de confinement gêne le passage des électrons et donc nuit au fonctionnement du transistor jusqu'à même aller à son non-fonctionnement.

La zone de confinement des porteurs peut être réalisée soit sous la forme d'un GRINSCH, soit sous la forme d'un super-réseau. La structure réseau étant plus facile à obtenir, on réalise de préférerce la seconde couche semi-conductrice ou couche active de la structure sous cette forme. Le super-réseau est formé, selon l'invention, d'une première série de couches minces parallèles d'épaisseur identique, réalisées en un premier matériau, et d'une seconde série de couches rinces parallèles, d'épaisseur identique, réalisées en un second matériau ayant une largeur de bande supérieure à celle du premier matériau, les première et seconde séries étant alternées.

Afin d'assurer une bonne prise de contact sur la base du transistor, la structure semi-conductrice selon l'invention sera avantageusement pourvue d'une seconde région, s'étendant au moins d'une face à l'autre de la troisième couche, ayant le second type de conductivité.

De façon avantageuse, la structure semi-conductrice selon l'invention comprend une quatrième couche semi-conductrice, intercalée entre la seconde et la troisième couches, dont la composition varie graduellement pour présenter à l'interface quatrième couche-troisième couche, la composition de la troisième couche, et à l'interface quatrième couche-seconde couche, la composition en surface de la seconde couche.

De même, la structure selon l'invention peut comprendre une cinquième couche semi-conductrice, intercalée entre la seconde et la première couches, dont la composition varie graduellement pour présenter, à l'interface cinquième couche-seconde couche la composition en surface de la seconde couche et à l'interface cinquième couche-première couche la composition de la première couche.

Ces couches de composition graduelles permettent d'augmenter la mobilité des électrons dans le transistor bipolaire de l'émetteur vers la base et le collecteur par rapport à une structure abrupte (passage direct d'un matériau de faible largeur de bande interdite à un matériau de forte largeur de bande interdite et réciproquement).

La structure semi-conductrice selon l'invention est réalisée en particulier sur un substrat semi-conducteur monocristallin en matériau III-V qui peut être de l'InP, du GaAs, du GaSb, du InAs ou du InSb. Ces matériaux III-V correspondent à des matériaux à faible largeur de bande interdite. Suivant le substrat utilisé, le matériau ayant une largeur de bande interdite élevée sera de la forme GaInAs, GaInAsP, AlInAs, GaAlInAs ou GaAlAs.

De préférence, la structure selon l'invention est réalisée sur un substrat en GaAs, la première couche est réalisée en $Ga_{1-x}Al_xAs$ de type N avec $0 \leq x \leq 1$, la troisième couche est réalisée en $Ga_{1-t}Al_tAs$ de type N, avec $0 \leq t \leq 1$, le premier matériau est réalisé en GaAs de type p et le second matériau est réalisé en $Ga_{1-y}Al_yAs$ de type P avec $0 \leq y < 1$. En particulier, y est varié de 0 à 0,45.

Avec une telle structure, on obtient une source laser émettant notamment à une longueur d'onde de 0,85 $\mu$m. Cette structure peut donc être utilisée avantageusement dans le domaine des télécommunications à courtes distances.

Les inventeurs ont pu déterminer que la compatibilité entre le laser et le transistor bipolaire était liée à l'épaisseur du second matériau ayant la largeur de bande interdite la plus élevée. Avantageusement, l'épaisseur de ces couches est telle que le facteur b $\sqrt{w}$ va de 1,2 à 1,9 nm $\sqrt{V}$, b étant l'épaisseur de ces couches et w la différence des énergies de conduction entre le premier matériau et le second matériau. Ces valeurs sont données à titre indicatif pour une valeur de Y telle que $0 < Y \leq 0,45$.

Afin d'augmenter la mobilité des électrons dans le transistor en abaissant la résistance de la base, le second matériau à largeur de bande la plus élevée contient avantageusement un plus grand nombre de dopants du second type et en particulier de type p que le premier matériau à faible largeur de bande interdite. Toutefois, il est tout fait possible d'utiliser le même dopage pour les premier et second matériaux.

La structure semi-conductrice selon l'invention peut être réalisée de façon simple en épitaxiant les différentes couches semi-conductrices la constituant sur un substrat en matériau III-V.

Par ailleurs, afin de minimiser la résistance de contact entre la troisième couche semi-conductrice et les électrodes d'amenée du courant au transistor et au laser, la structure semi-conductrice comporte avantageusement sur cette troisième couche une sixième couche semi-conductrice réalisée en un matériau ayant une largeur de bande interdite inférieure à celle de la troisième couche semi-conductrice.

La première couche et la troisième couches semi-conductrices de la structure selon l'invention peuvent jouer indépendamment le rôle d'émetteur ou de collecteur du transistor lorsque leur composition est relativement proche. Toutefois, par convention, la première couche semi-conductrice constitue généralement le collecteur et la troisième couche semi-conductrice l'émetteur. On utilisera cette convention dans la suite de la description.

D'autres caractéristiques et avantages de l'invention ressortiront mieux de la description qui va suivre, donnée à titre illustratif et non limitatif, en référence aux figures annexées, dans lesquelles :

- la figure 1 représente en coupe longitudinale la structure semi-conductrice selon l'invention,
- la figure 2 représente schématiquement un premier mode de réalisation de la couche active de la structure semi-conductrice selon l'invention,
- la figure 3 est un diagramme donnant le logarithme de la mobilité des porteurs en fonction de l'épaisseur du matériau à forte bande interdite et de la différence d'énergie de conduction entre les premier et second matériaux constituant le super-réseau,
- la figure 4 est un schéma électrique correspondant de la structure représentée sur la figure 1, et
- la figure 5 correspond à un second mode de réalisation de la couche active de la structure selon l'invention ; elle représente un diagramme donnant la composition y en aluminium de cette couche en fonction de la profondeur de cette couche.

La description ci-après se réfère à une structure semi-conductrice du type GaAs/GaAlAs. Le GaAs correspond au matériau de faible bande interdite et le GaAlAs au matériau de plus forte largeur de bande interdite.

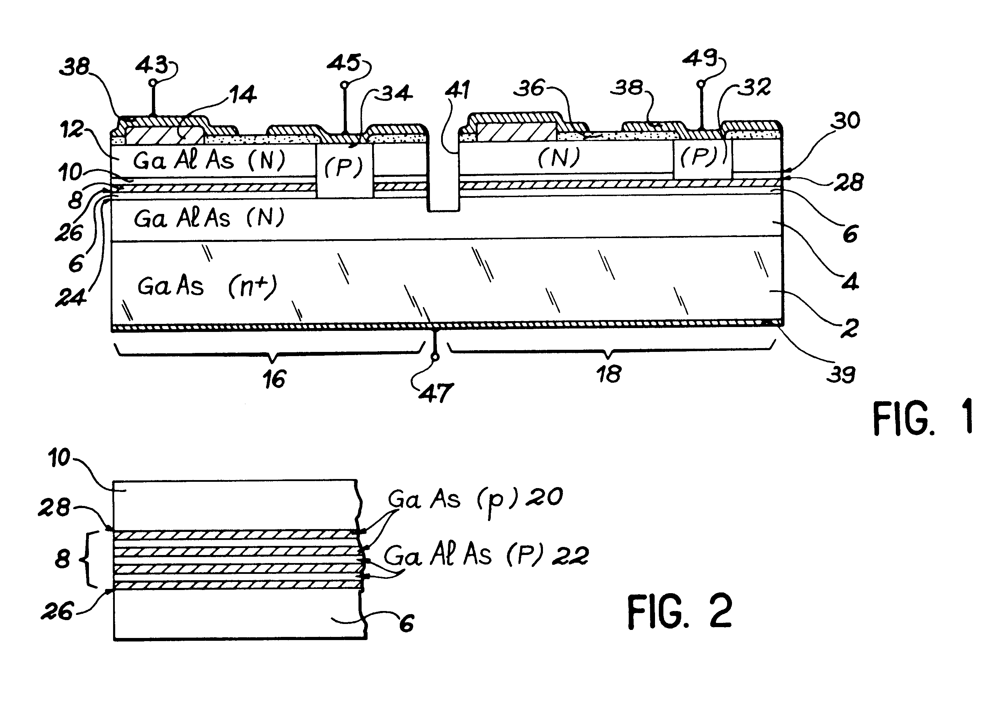

Sur la figure 1, on a représenté, en coupe longitudinale, la structure semi-conductrice selon l'invention. Cette structure transistor-laser comprend un substrat semi-conducteur 2 en GaAs de type $n^+$. Le dopage du type $n^+$ est obtenu avec des ions de silicium à une concentration de $10^{17}$ atomes/cm$^3$. Sur ce substrat 2, sont déposées, par épitaxie chimique en phase vapeur à partir de composés organiques (MOCVD) ou par épitaxie par jets moléculaires (MBE), six couches semi-conductrices l'une au-dessus de l'autre, qui, en partant du substrat 2, portent les références 4, 6, 8, 10, 12, 14.

La couche 4 est réalisée en $Ga_{1-x}Al_xAs$ de type N avec $0 \leq x \leq 1$. Cette couche 4 peut présenter une épaisseur d'environ 3 $\mu m$ et être réalisée en $Ga_{0,6}Al_{0,4}As$, ou GaAs. Le dopage N est obtenu avec des ions de silicium à une concentration $5.10^{17}$ atomes/cm$^3$. Cette couche 4 constitue le collecteur du transistor 16 et une couche de confinement des électrons et des trous pour le laser 18.

La couche 8, formant la base du transistor 16 et la couche active du laser 18, présente une structure de super-réseau comme représentée sur la figure 2. Cette couche 8 est formée d'un empilement de deux séries alternées de couches différentes : des couches 20 en GaAs de type p et des couches 22 en $Ga_{1-y}Al_yAs$ de type P avec $0 \leq y < 1$. De préférence, y satisfait à la relation $0 < y \leq 0,45$ et en particulier y vaut 0,24. Les couches 20 et 22 forment une structure périodique, chaque couche 20 étant intercalée entre deux couches 22 et réciproquement.

Cet empilement de couches ou super réseau constitue une multitude de puits quantiques, (MQW), les puits correspondant au GaAs, les barrières au $Ga_{1-y}Al_yAs$. Il permet d'obtenir une source laser 18 à faible courant de seuil, entraînant l'utilisation de courant plus faible pour moduler le laser.

Afin d'augmenter la vitesse de déplacement des électrons pour le transistor 16, les couches 22 de largeur de bande interdite la plus élevée peuvent être plus fortement dopées en ions de type p que les couches 20. En particulier, les couches 22 peuvent être dopées avec du béryllium à une concentration de $10^{19}$ atomes/cm$^3$ et les couches 20 peuvent être dopées avec du béryllium à une concentration de $10^{18}$ atomes/cm$^3$. Ceci permet de conserver une résistance de base du transistor relativement faible et en particulier, une résistance de base par carré inférieure ou égale à 1000 ohms.

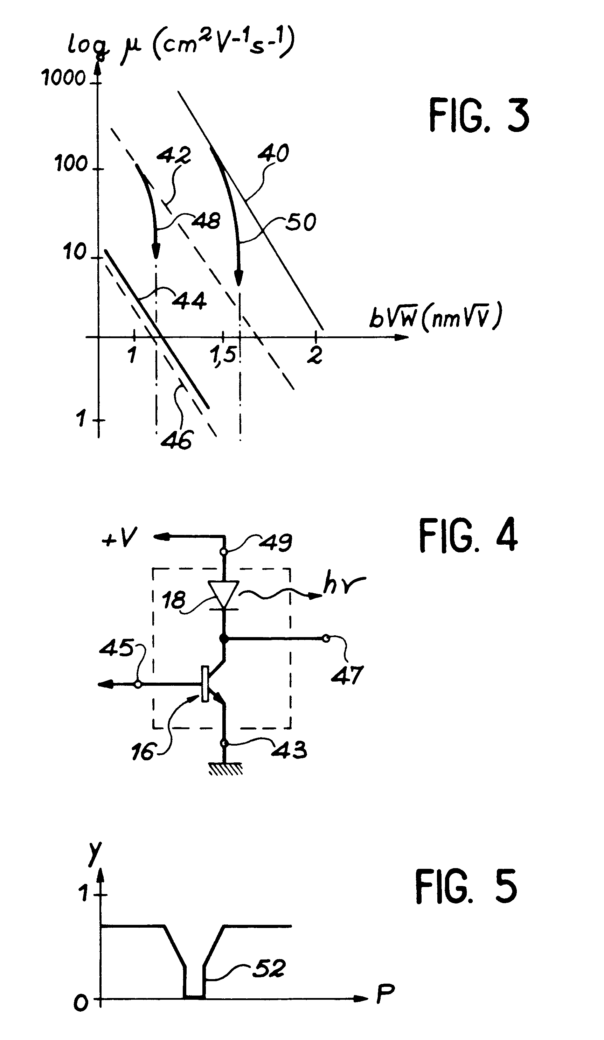

Dans l'exemple particulier de y compris entre 0,21 et 0,3 les couches 22 présentent une épaisseur allant de 2,5 à 3,5 nm allant de 3,2 à 3,5 nm. Les couches 20 présentent une épaisseur allant de 3 à 10 nm et par exemple égale à 4,5 nm. L'influence de l'épaisseur des couches 20 et 22 sur le fonctionnement de la structure sera décrite plus en détail en regard de la figure 3.

Le nombre de couches 20 et 22 constituant la couche active 8 de la structure sont de préférence tel que l'épaisseur de la couche active est un multiple de 0,25 nm, ce chiffre correspondant à une demi-maille de la structure cristalline du GaAs. La couche active 8 présente par exemple une épaisseur de 0,25 $\mu m$.

La couche 12 semi-conductrice dans laquelle sont réalisés l'émetteur du transistor 16 et la jonction PN du laser 18, est réalisée en $Ga_{1-t}Al_tAs$ de type N avec $0 \leq t \leq 1$. En particulier, cette couche 12 peut être realisée en $Ga_{0,72}Al_{0,28}As$ et présenter une épaisseur de 1 $\mu$m. Le dopage N est obtenu avec des ions de silicium à une concentration de $5.10^{17}$ atomes/cm$^3$.

La teneur en aluminium des couches 4, 12 et 22 peut être quelconque à condition que la largeur de bande interdite des couches 4 et 12 soit au moins égale à celle des couches 22 pour que le transistor 16 fonctionne correctement.

La couche semi-conductrice 6 intercalée entre les couches semi-conductrices 4 et 8 présente une composition variant graduellement.

A l'interface 24 de la couche 4 et de la couche 6, la composition de la couche 6 est égale à celle de la couche 4 et présente en particulier la composition $Ga_{0,6}Al_{0,4}As$. A l'interface 26, entre la couche 6 et la couche 8, la couche 6 présente une composition égale à celle de la première couche formant le superréseau, et en particulier est réalisée en GaAs.

De même que la composition, le dopage de la couche 6 varie graduellement. En particulier, à l'interface 24 la couche 6 peut être dopée avec des ions de silicium (type n) à une concentration inférieure à $5.10^{16}$ et à l'interface 26 avec des ions de silicium à une concentration de $2.10^{17}$ atomes/cm$^3$.

Cette couche 6 présente une épaisseur d'environ 30 nm.

De même, la couche semi-conductrice 10 intercalée entre la couche active 8 et la couche semi-conductrice 12 présente une composition variant graduellement afin de présenter à l'interface 28 entre la couche 8 et la couche 10 une composition égale à celle de la dernière couche du réseau 8, et en particulier une composition du type GaAs (voir figure 2) et afin de présenter à l'interface 30 entre la couche 10 et la couche 12 une composition égale à celle de la couche 12 et en particulier une composition du type $Ga_{0,72}Al_{0,28}As$.

De même que la composition de cette couche varie, le dopage varie. La concentration d'ions silicium à l'interface 28 est inférieure à celle de l'interface 30. A l'interface 28, la concentration est par exemple égale à $5.10^{16}$ atomes/cm$^3$ et à l'interface 30 égale à $2.10^{17}$ atomes/cm$^3$.

La couche 10 présente une épaisseur de 30 nm.

La couche semi-conductrice 14, au contact de la couche 12, présente une composition telle que sa largeur de bande interdite est inférieure à celle de la couche 12. En particulier, cette couche 14 peut être réalisée en GaAs et être dopée de type n. Cette couche semi-conductrice 14 sert de prise de contact pour l'émetteur du transistor 16. Elle peut présenter une épaisseur de 0,2 $\mu$m.

La structure représentée sur la figure 1 comprend encore deux régions implantées de type P 32 et 34 servant respectivement à former la jonction PN du laser 18 et à la prise de contact sur la base du transistor 16. Ces deux régions sont obtenues, par exemple, en implantant des ions béryllium à une dose de $3.10^{15}$ atomes/cm$^2$ puis en effectuant un recuit thermique à 800°C.

De façon avantageuse, la zone implantée 34 servant de prise de contact sur la base du transistor, traverse de part en part la couche 12, la couche 10, la couche 8 et la couche 6. En revanche, la couche implantée 32 formant la jonction PN du laser ne traverse que les couches 12 et 10 de part en part.

L'ensemble de la structure est équipé d'une couche isolante 36 par exemple en oxyde de silicium gravée de manière appropriée afin de permettre la prise de contact sur l'émetteur et la base du transistor 16 d'une part et d'autre part, sur la région N et sur la région P du laser. Cette couche d'oxyde de silicium 36 est recouverte d'une couche en aluminium 38 dans laquelle sont définies les électrodes de l'émetteur et de la base du transistor et l'électrode de la région P du laser.

En outre, la structure est équipée d'une électrode 39 recouvrant la partie inférieure de la structure, servant relier électriquement la jonction N du laser 18 au collecteur du transistor 16.

Enfin, on effectue une fenêtre 41 traversant de part en part les couches 38, 36, 12, 10, 8 et 6 afin d'isoler électriquement le transistor 16 et la laser 18.

Sur la figure 4, on a schématisé le circuit électrique équivalent de la structure représentée sur la figure 1. Les références 43, 45 et 47 correspondent respectivement aux bornes de l'émetteur de la base et du collecteur du transistor et la référence 49 à la borne de la jonction P du laser. Le fonctionnement de la structure est assuré en appliquant un potentiel +V à la borne 49 et en connectant l'émetteur à la masse.

L'intérêt du transistor bipolaire à hétérojonction tel que décrit ci-dessus est dû à sa grande dynamique de tri entre les porteurs, c'est-à-dire entre les électrons et les trous. En effet, la barrière en énergie que les porteurs minoritaires, ici les trous, ont à franchir pour aller de la base dans l'émetteur fait que le gain d'une telle structure est très élevé. En effet, le gain d'une telle structure est donné par le rapport $I_c/I_b$, $I_c$ représentant le courant circulant dans le collecteur et $I_b$ le courant circulant dans la base.

Dans la structure de l'invention, les trous et les électrons du laser se déplacent perpendiculairement aux couches. Les trous du transistor se déplacent parallèlement aux couches et les électrons du transistor perpendiculairement aux couches.

Sur la figure 3, on a représenté le logarithme de la mobilité $\mu$ des porteurs dans la structure super-réseau, selon une direction perpendiculaire aux plans des couches, en fonction d'un paramètre

$b \sqrt{w}$, où b est la largeur de la barrière du super-réseau, c'est-à-dire l'épaisseur des couches 22 de largeur de bande interdite la plus élevée et w la différence des énergies de conduction entre les puits et la barrière, qui est une énergie de potentiel de barrière, le puits correspondant aux couches 20 du super-réseau de largeur de bande interdite la plus faible. La valeur de w est directement proportionnelle à la concentration en aluminium du matériau semi-conducteur. Dans le cas représenté la concentration y en aluminium satisfait à la relation $0 < y \leq 0,45$. Le logarithme de la mobilité des porteurs est exprimé en $cm^2 \, V^{-1} S^{-1}$ et correspond à la rapidité de déplacement des porteurs.

Sur le diagramme, la droite 40 représente la conduction idéale des électrons par état de BLOCH ou ondes de BLOCH. Cette courbe 40 correspond à une structure de réseau périodique dans laquelle les matériaux des puits et des barrières sont purs. De même, la ligne en pointillés 42 correspond à la conduction par état de BLOCH des trous, pour un matériau idéal.

La courbe 44 correspond à une conduction par sauts quantiques des électrons (passage d'un électron d'un puits à une barrière, c'est-à-dire d'une couche 20 à une couche 22) et la ligne discontinue 46 à une conduction par sauts quantiques des trous. Les conductions symbolisées par les courbes 44 et 46 sont obtenues par un super réseau fabriqué sans aucune précaution particulière.

La détermination théorique des courbes 40-46 a fait l'objet de plusieurs publications : en particulier l'article IBM Jal. Res. and Dev. 14(1970), p. 61 et suivantes de L. ESAKI et R. TSU, et l'article JAL. de Physique 43(1982), p. 381 et suivantes de JF. PALMIER et A. CHOMETTE.

Enfin, les courbes 48 et 50 correspondent au logarithme de la mobilité des porteurs en fonction du paramètre $b\sqrt{w}$, selon une direction perpendiculaire aux couches.

Etant donné que la masse effective des trous est beaucoup plus élevée que celle des électrons, le passage de la conduction de bande (courbes 40 et 42) à la conduction par sauts (courbes 44 et 46) ne se fait pas aux mêmes valeurs du paramètre $b \sqrt{w}$ pour les trous et les électrons.

L'utilisation d'un super-réseau dont le paramètre $b\sqrt{w}$ varie de 1,2 à 1,9 nm par $\sqrt{V}$, avec $0 < y \leq 0,45$, permet de renforcer la hauteur de barrière pour les trous (porteurs lents) mais laisse passer les électrons (porteurs rapides) ; ceci permet d'obtenir un gain suffisamment élevé pour le transistor.

Les inventeurs ont réalisé des structures telles que décrites précédemment dans lesquelles les couches 4 et 8 étaient respectivement réalisées en GaAs dopé Si à $5.10^{16}$ et en $Ga_{0,72}Al_{0,28}As$ dopé Si à $5.10^{17}$. Les couches 22 étaient réalisées en $Ga_{0,76}Al_{0,24}As$ dopé béryllium à $3.10^{16}/cm^3$ et les couches 20 étaient réalisées en GaAs non intentionnellement dopé ; l'épaisseur des couches 22 était de 2,25 nm dans un premier exemple et de 4,5 nm dans un second exemple tandis que l'épaisseur des couches 20 était pour les deux exemples de 4, 5 nm. Dans le premier exemple, le transistor obtenu avait un gain supérieur à 500 tandis que dans le second cas, le gain était voisin de 1.

Par ailleurs, des études ont été faites sur un laser comportant un super-réseau dans la couche active. Ces études ont permis de démontrer que la meilleure efficacité du laser, c'est-à-dire la plus grande quantité de recombinaisons entre les électrons et les trous, était obtenue pour des épaisseurs de barrière de 3,2 à 3,5 nm lorsque la concentration en aluminium des couches barrières 22 est comprise entre 0,2 et 0,3.

Compte tenu de ce qui précède, les inventeurs ont trouvé que des barrières, de composition y comprise entre 0,2 et 0,3, ayant une épaisseur comprise entre 3,2 et 3,5 nm et en particulier égales à 3,3 nm permettaient, dans le cas précis, de rendre compatible un laser et un transistor bipolaire à hétérojonction en utilisant une structure super-réseau pour former la couche active du laser et la base du transistor.

Dans le même ordre d'idée, il est possible de remplacer la structure super-réseau de la couche 8 formant la base du transistor et la couche active du laser par un GRINSCH.

Sur la figure 5, on a représenté les variations de la composition y d'une couche en $Ga_{1-y}Al_yAs$ constituant la couche active 8 en fonction de la profondeur de cette couche. Le GRINSCH définit, comme le super réseau, une zone de confinement 52 des trous et des électrons dans le laser, et donc l'assurance d'une forte recombinaison de ces porteurs, et un blocage des trous pour le transistor bipolaire et donc l'assurance d'un gain élevé du transistor.

Les épaisseurs des barrières données ci-dessus correspondent bien entendu à une structure du type GaAs/GaAlAs avec une composition y particulière. La détermination de l'épaisseur des barrières pour d'autres structures peut être déterminée de la même façon à partir d'une courbe donnant le logarithme de la mobilité des porteurs en fonction du paramètre $b\sqrt{w}$.

L'épaisseur, le dopage et la composition des différentes couches semi-conductrices de la structure laser-transistor bipolaire peuvent être modifiés à condition de respecter les conditions spécifiques liées aux largeurs de bande interdite des différents matériaux formant les différentes couches de la structure.

Par ailleurs, il est possible de réaliser une structure équivalente avec un transistor de type PNP et une région N implantée pour le laser. Pour cela, il suffit de remplacer tous les dopages au silicium par du dopage au béryllium et réciproquement.

## Revendications

1. Structure semi-conductrice monolithique d'un transistor bipolaire à hétérojonction et d'un laser isolés électriquement l'un de l'autre, caractérisée en ce qu'elle comprend :
   - une hétérostructure comportant une première (4), une seconde (8) et une troisième (12) couches semi-conductrices superposées dans cet ordre, la première (4) et la troisième (12) couches étant réalisées en des matériaux d'un premier type de conductivité ayant des largeurs de bande interdite au moins égales à celle de la seconde couche (6), cette seconde couche, constituant la couche active du laser (18) et la base du transistor (16), présentant un second type de conductivité différent du premier type et étant constituée d'une hétérostructure de plusieurs matériaux (20, 22) de largeur de bande interdite différente, définissant au moins une zone de confinement (52, 20) des porteurs uniquement pour le laser, orientée parallèlement aux première et troisième couches,
   - une première région (32) s'étendant au moins d'une face à l'autre de la troisième couche (12) et ayant le second type de conductivité, cette première région (32) définissant avec la troisième couche la jonction du laser (18), et
   - des moyens (14, 38, 39) pour alimenter en courant le laser (18) et le transistor (16).

2. Structure semi-conductrice selon la revendication 1, caractérisée en ce que la seconde couche (8) est un super-réseau formé d'une première série de couches minces (20) parallèles d'épaisseur identique, réalisées en un premier matériau, et d'une seconde série de couches minces (22) parallèles d'épaisseur identique, réalisées en un second matériau ayant une largeur de bande supérieure à celle du premier matériau, les première et seconde séries de couches (20, 22) étant alternées.

3. Structure semi-conductrice selon la revendication 1 ou 2, caractérisée en ce qu'elle comprend une seconde région (34) s'étendant au moins d'une face à l'autre de la troisième couche et ayant le second type de conductivité, cette seconde région (34) servant de contact électrique pour la base du transistor (16).

4. Structure semi-conductrice selon l'une quelconque des revendications 1 à 3, caractérisée en ce qu'elle comprend une quatrième couche semi-conductrice (10), intercalée entre la seconde (8) et la troisième (12) couches, dont la composition varie graduellement pour présenter à l'interface (30) quatrième couche-troisième couche, la composition de la troisième couche (12), et à l'interface (28) quatrième couche-seconde couche, la composition en surface de la seconde couche (8).

5. Structure semi-conductrice selon l'une quelconque des revendications 1 à 4, caractérisée en ce qu'elle comprend une cinquième couche semi-conductrice (6), intercalée entre la seconde (8) et la première (4) couches, dont la composition varie graduellement pour présenter, à l'interface (26) cinquième couche-seconde couche, la composition en surface de la seconde couche (2) et à l'interface (24) cinquième couche-première couche la composition de la première couche (4).

6. Structure semi-conductrice selon l'une quelconque des revendications 2 à 5, caractérisée en ce que la première (4) couche est réalisée en $Ga_{1-x}Al_xAs$ de type N avec $0 \leq x \leq 1$, la troisième couche (12) est réalisée en $Ga_{1-t}Al_tAs$ de type N avec $0 \leq t \leq 1$, le premier matériau est réalisé en GaAs de type p et le second matériau est réalisé en $Ga_{1-y}Al_yAs$ de type P avec $0 \leq y < 1$.

7. Structure semi-conductrice selon la revendication 6, caractérisée en ce que y satisfait à la relation $0 < y \leq 0,45$.

8. Structure semi-conductrice selon la revendication 7, caractérisée en ce que les couches minces (22) de la seconde série présentent une épaisseur b satisfaisant à la relation $1,2 \leq b\sqrt{w} \leq 1,9$ dans laquelle w représente la différence des énergies de conduction entre le premier matériau et le second matériau.

9. Structure semi-conductrice selon l'une quelconque des revendications 2 à 8, caractérisée en ce que le second matériau contient un plus grand nombre de dopants du second type que le premier matériau.

10. Structure semi-conductrice selon l'une quelconque des revendications 5 à 9, caractérisée en ce que la seconde région (34) s'étend de la surface supérieure de la troisième couche (12) à la face inférieure de la cinquième couche (6).

11. Structure semi-conductrice selon l'une quelconque des revendications 4 à 10, caractérisée en ce que la première région (32) s'étend de la surface supérieure de la troisième couche (12) à la face inférieure de la quatrième couche (10).

12. Structure semi-conductrice selon l'une quelconque des revendications 1 à 9, caractérisée en ce qu'elle comprend un substrat semi-conducteur, sur lequel sont épitaxiées les couches semi-conductrices, et une sixième couche semi-conductrice au contact de la troisième couche servant de contact électrique, cette sixième couche étant réalisée en un matériau ayant une largeur de bande interdite inférieure à celle du matériau de la troisième couche.

**Claims**

1. Monolithic semiconductor structure of a bipolar heterojunction transistor and a laser electrically insulated from one another, characterized in that it comprises a heterostructure having a first (4), a second (8) and a third (12) semiconductor layers superimposed in this order, the first (4) and third (12) layers being produced from materials having a first type of conductivity with forbidden band widths at least equal to those of the second layer (6), whereby the latter, which constitutes the active layer of the laser (18) and the base of the transistor (16) has a second conductivity type differing from the first type and being formed by a heterostructure of several materials (20, 22) having different forbidden band widths, defining at least one confinement zone (52, 20) of the carriers solely for the laser, oriented parallel to the first and third layers; a first region (32) extending at least from one face to the other of the third layer (12) and having the second conductivity type, said first region (32) defining with the third layer the junction of the laser (18) and means (14, 38, 39) for supplying current to the laser (18) and the transistor (16).

2. Semiconductor structure according to claim 1, characterized in that the second layer (8) is a super-lattice formed from a first series of thin parallel layers (20) having an identical thickness and made from a first material and a second series (22) of parallel thin layers having an identical thickness and made from a second material having a band width greater than that of the first material, the first and second series of layers (20, 22) alternating.

3. Semiconductor structure according to claims 1 or 2, characterized in that it comprises a second region (34) extending at least from one face to the other of the third and having the second conductivity type, said second region (34) serving as an electric contact for the base of the transistor (16).

4. Semiconductor structure according to any one of the claims 1 to 3, characterized in that it comprises a fourth semiconductor layer (10) placed between the second (8) and third (12) layers and whose composition varies gradually, so that at the interface (30) between the fourth and third layers it has the composition of the third layer (12) and at the interface (28) between the fourth and second layers the surface composition of the second layers (8).

5. Semiconductor structure according to any one of the claims 1 to 4, characterized in that it comprises a fifth semiconductor layer (6) inserted between the second (8) and first (4) layers and whose composition varies gradually, so that at the interface (26) between the fifth and second layers it has the surface composition of the second layer (2) and at the interface (24) between the fifth and first layers the composition of the first layer (4).

6. Semiconductor structure according to any one of the claims 2 to 5, characterized in that the first layer (4) is made of type n $Ga_{1-x}Al_xAs$ with $0 \leq x \leq 1$, the third layer (12) being made from type n $Ga_{1-t}Al_tAs$ with $0 \leq t \leq 1$, the first material being of p type GaAs and the second material of p type $Ga_{1-y}Al_yAs$ with $0 \leq y < 1$.

7. Semiconductor structure according to claim 6, characterized in that y satisfies the relation $0 < y \leq 0.45$.

8. Semiconductor structure according to claim 7, characterized in that the thin layers of the second series have a thickness b satisfying the relation $1.2 \leq b \sqrt{w} \leq 1.9$, in which w represents the difference of the conduction energies between the first and second materials.

9. Semiconductor structure according to any one of the claims 2 to 8, characterized in that the second material contains a larger number of dopants of the second type than the first material.

10. Semiconductor structure according to any one of the claims 5 to 9, characterized in that the second region (34) extends from the upper surface of the third layer (12) to the lower surface of the fifth layer (6).

11. Semiconductor structure according to any one of the claims 4 to 10, characterized in that the first region (32) extends from the upper surface of the third layer (12) to the lower surface of the fourth layer (10).

12. Semiconductor structure according to any one of the claims 1 to 9, characterized in that it comprises a semiconductor substrate on which are epitaxied the semiconductor layers and a sixth semiconductor layer in contact with the third layer serving as an electric contact, said sixth layer being produced from a material having a forbidden band width below that of the material of the third layer.

**Patentansprüche**

1. Einkristalline Halbleiterstruktur aus einem Bipolartransistor mit Heteroübergang und einem Laser, die elektrisch voneinander isoliert sind, dadurch gekennzeichnet, daß sie umfaßt:
   - eine Heterostruktur mit einer ersten (4), einer zweiten (8) und einer dritten (12) Halbleiterschicht, die in dieser Reihenfolge übereinander angeordnet sind, wobei die erste (4) und die dritte (12) Schicht aus Materialien eines ersten Leitfähigkeitstyps mit einer Breite des verbotenen Bandes von wenigstens der Breite der zweiten Schicht (6) gefertigt sind, wobei diese zweite Schicht, die die aktive Schicht des Lasers (18) und die Basis des Transistors (16) bildet, einen zweiten Leitfähigkeitstyp aufweist, der von dem ersten verschieden ist, und aus einer Heterostruktur einer Mehrzahl von Materialien (20, 22) mit verschiedener Breite des verbotenen Bandes besteht, die wenigstens eine Einschließungszone (52, 20) für Ladungsträger nur für den Laser bildet, die parallel zu der ersten und dritten Schicht ausgerichtet ist,
   - einen ersten Bereich (32), der sich wenigstens von einer Seite bis zur anderen Seite der dritten Schicht (12) erstreckt und den zweiten Leitfähigkeitstyp besitzt, wobei der erste Bereich (32) mit der dritten Schicht den Übergang des Lasers (18) bildet, und
   - Vorrichtungen (14, 38, 39) zum Versorgen des Lasers (18) und des Transistors (16) mit Strom.

2. Halbleiterstruktur nach Anspruch 1, dadurch gekennzeichnet, daß die zweite Schicht (8) ein Übergitter ist, das aus einer Reihe von dünnen, parallelen Schichten (20) mit identischer Dicke aus einem ersten Material und einer zweiten Reihe von dünnen, parallelen Schichten (22) mit identischer Dicke aus einem zweiten Material, dessen Bandbreite größer als die des ersten Materials ist, besteht, wobei die erste und die zweite Reihe von Schichten (20, 22) einander abwechseln.

3. Halbleiterstruktur nach Anspruch 1 oder 2, dadurch gekennzeichnet, daß sie einen zweiten Bereich (34) umfaßt, der sich wenigstens von einer Seite bis zur anderen der dritten Schicht erstreckt und den zweiten Leitfähigkeitstyp besitzt, wobei dieser zweite Bereich (34) als elektrischer Kontakt für die Basis des Transistors (16) dient.

4. Halbleiterstruktur nach einem der Ansprüche 1 bis 3, dadurch gekennzeichnet, daß sie eine vierte halbleitende Schicht (10) umfaßt, die zwischen der zweiten (8) und der dritten (12) Schicht angeordnet ist und deren Zusammensetzung sich schrittweise ändert, um an der Grenzfläche (30) vierte Schicht-dritte Schicht die Zusammensetzung der dritten Schicht (12) und an der Grenzfläche (28) vierte Schicht-zweite Schicht die Oberflächenzusammensetzung der zweiten Schicht (8) aufzuweisen.

5. Halbleiterstruktur nach einem der Ansprüche 1 bis 4, dadurch gekennzeichnet, daß sie eine vierte halbleitende Schicht (6) umfaßt, die zwischen der zweiten (8) und der ersten (4) Schicht angeordnet ist und deren Zusammensetzung sich schrittweise ändert, um an der Grenzfläche (26) fünfte Schicht-zweite Schicht die Oberflächenzusammensetzung der zweiten Schicht (8) und an der Grenzfläche (24) fünfte Schicht-erste Schicht die Zusammensetzung der ersten Schicht (4) aufzuweisen.

6. Halbleiterstruktur nach einem der Ansprüche 2 bis 5, dadurch gekennzeichnet, daß die erste Schicht (4) aus N-Typ $Ga_{1-x}Al_xAs$ mit $0 \leq x \leq 1$, die dritte Schicht (12) aus N-Typ $Ga_{1-t}Al_tAs$ mit

$0 \leq t \leq 1$, das erste Material aus P-Typ GaAs und das zweite Material aus P-Typ $Ga_{1-y}Al_yAs$ mit $0 \leq y < 1$ besteht.

7. Halbleiterstruktur nach Anspruch 6, dadurch gekennzeichnet, daß y die Bedingung $0 < y \leq 0,45$ erfüllt.

8. Halbleiterstruktur nach Anspruch 7, dadurch gekennzeichnet, daß die dünnen Schichten (22) der zweiten Reihe eine Dicke b aufweisen, die die Beziehung $1,2 \leq b\sqrt{w} \leq 1,9$ erfüllt, in der w die Differenz der Leitfähigkeitsenergien des ersten Materials und des zweiten Materials darstellt.

9. Halbleiterstruktur nach einem der Ansprüche 2 bis 8, dadurch gekennzeichnet, daß das zweite Material eine größere Anzahl von Dotierstoffen des zweiten Typs enthält als das erste Material.

10. Halbleiterstruktur nach einem der Ansprüche 5 bis 9, dadurch gekennzeichnet, daß der zweite Bereich (34) sich von der oberen Oberfläche der dritten Schicht (12) bis zur Unterseite der fünften Schicht (6) erstreckt.

11. Halbleiterstruktur nach einem der Ansprüche 4 bis 10, dadurch gekennzeichnet, daß der erste Bereich (32) sich von der oberen Oberfläche der dritten Schicht (12) bis zur Unterseite der vierten Schicht (10) erstreckt.

12. Halbleiterstruktur nach einem der Ansprüche 1 bis 9, dadurch gekennzeichnet, daß sie ein halbleitendes Substrat umfaßt, auf dem epitaktisch die halbleitenden Schichten und eine sechste halbleitende Schicht aufgebracht sind, die mit der dritten Schicht, die als elektrischer Kontakt dient, in Kontakt steht, wobei diese sechste Schicht aus einem Material gefertigt ist, das eine Breite des verbotenen Bandes besitzt, die kleiner ist als die des Materials der dritten Schicht.

FIG. 1

FIG. 2

FIG. 3

FIG. 4

FIG. 5